# EUROPEAN PATENT APPLICATION

(11) **EP 4 757 114 A1**
(43) Date of publication of application: **10.06.2026**
(21) Application number: 25218585.5
(22) Date of filing: 26.11.2025
(51) Int. Cl.: H02J 7/44, H01M 10/42, H02J 7/50

(54) **BATTERY MANAGEMENT SYSTEM, OPERATING METHOD THEREOF, AND ENERGY STORAGE SYSTEM**

(30) Priority: 05.12.2024 KR 20240179602
(71) Applicant: SAMSUNG SDI CO., LTD., Yongin-si, Gyeonggi-do 17084 (KR)
(72) Inventor: HWANG, Gi Chan, 16678 Suwon-si (KR); YOO, Ji Won, 16678 Suwon-si (KR)
(74) Representative: Maiwald GmbH

(57) **Abstract**

Disclosed herein are a battery management system, BMS, an operating method thereof, and an energy storage system, ESS, and a technical problem to be solved is to provide a hard fault handling mechanism that can improve operational stability of the ESS. To this end, the present disclosure employs a configuration in which, when a hard fault occurs, error occurrence information is stored in a reference area of a memory, and then information in the reference area of the memory is read when the BMS wakes up, and an operation of the ESS is started or a protection operation is performed according to a read result.

## Description

### FIELD

The present disclosure relates to a battery management system (BMS), an operating method thereof, and an energy storage system (ESS).

### BACKGROUND

An energy storage system (ESS) is a system that can store surplus electricity or power produced using new renewable energy. Idle power can be stored using an ESS during times of low electricity demand, and the power stored in the ESS can be supplied to a power grid system and consumers during times of high electricity demand so that power supply and demand can be smoothly controlled.

An ESS includes a battery serving as an energy source that stores power or extracts power, a battery management system (BMS) that monitors a state of the battery and controls the battery or performs a protection operation on the basis of the monitoring result, a power conversion system (PCS) that performs AC-DC conversion and distribution functions between a power grid system and the battery, and an energy management system (EMS) that monitors an operating state of the ESS, collects and manages state data, and integrally controls the ESS. The battery includes a plurality of battery racks electrically connected to one another, each battery rack includes a plurality of battery modules electrically connected to one another, and each battery module includes a plurality of battery cells electrically connected to one another.

The herein information disclosed in this Background section is for enhancement of understanding of the background of the present disclosure, and therefore, it may contain information that does not constitute related (or prior) art.

### SUMMARY

The present disclosure is directed to providing a battery management system (BMS) and an operating method thereof, which can improve operational stability of an energy storage system (ESS), and the ESS.

However, objects that the present disclosure intends to achieve are not limited to the herein-described objects and other objects that are not described may be clearly understood by those skilled in the art from the following description.

According to aspects of the present disclosure, there is provided a BMS including a processor, and a memory configured to store a command executed by the processor, wherein, when an unhandleable error occurs during an operation of the battery, the processor stores error occurrence information indicating occurrence of the unhandleable error in a reference area of the memory corresponding to a predefined reference address, and when the BMS wakes up, the processor reads information in the reference area of the memory and determines whether to start operation of the battery on the basis of a read result.

The unhandleable error may be an error that is not allowed to be handled through a predefined exception handling mechanism for exception handling during the operation of the battery.

When the BMS wakes up, the processor may read the information in the reference area of the memory, determine whether the error occurrence information is stored in the reference area, and determine whether a cause of the unhandleable error is solved.

When the error occurrence information is stored in the reference area, the processor may determine that the cause of the unhandleable error is not solved and perform a predefined protection operation to protect the battery.

The BMS may further include a switch connected to a charging/discharging path that functions as a path for supplying a charging current or drawing a discharging current to or from the battery and configured to allow or block a current flow in the charging/discharging path, and when the protection operation is performed, the processor may turn the switch off to block the current flow in the charging/discharging path.

The BMS may further comprise a fuse connected to a charging/discharging path that functions as a path for supplying a charging current or drawing a discharging current to or from the battery and configured to block a current flow in the charging/discharging path when fused, and when the protection operation is performed, the processor may fuse the fuse to block the current flow in the charging/discharging path.

After the protection operation is performed, the processor may notify a higher level controller that the protection operation is performed or notify a user through an indicator.

When the error occurrence information is not stored in the reference area, the processor may start operation of the battery.

The reference address may have an address value different from an address of a storage area of the memory in which the command is stored.

According to aspects of the present disclosure, there is provided a method of operating a BMS, which includes determining, by a processor, whether an unhandleable error occurs during an operation of a battery; when it is determined that the unhandleable error occurs, storing, by the processor, error occurrence information indicating occurrence of the unhandleable error in a reference area of a memory corresponding to a predefined reference address; when the BMS wakes up, reading, by the processor, information in the reference area of the memory; and determining, by the processor, whether to start the operation of the battery on the basis of a read result of the reference area of the memory.

In determining whether to start operation of the battery, the processor may determine whether the error occurrence information is stored in the reference area and determine whether a cause of the unhandleable error is solved.

When it is determined that the error occurrence information is stored in the reference area, the processor may determine that the cause of the unhandleable error is not solved and determine not to start operation of the battery; and the method may further comprise, when it is determined not to start the operation of the battery, performing, by the processor, a predefined protection operation.

The BMS may include a switch connected to a charging/discharging path that functions as a path for supplying a charging current or drawing a discharging current to or from the battery and configured to allow or block a current flow in a charging/discharging path, and in the performing the predefined protection operation, the processor may turn the switch off to block the current flow in the charging/discharging path.

The BMS may include a fuse connected to a charging/discharging path that functions as a path for supplying a charging current or drawing a discharging current to or from the battery and configured to block the current flow in the charging/discharging path when fused, and wherein, in the performing the predefined protection operation, the processor may fuse the fuse to block the current flow in the charging/discharging path.

The method may further include, after the performing the predefined protection operation, notifying, by the processor, a higher level controller that the predefined protection operation is performed or notifying a user through an indicator.

When it is determined that the error occurrence information is not stored in the reference area, the processor may determine to start the operation of the battery.

According to aspects of the present disclosure, there is provided an ESS including a battery, a processor, a battery management system (BMS) including a processor and a memory configured to store a command executed by the processor, and an energy management system (EMS) configured to serve as a higher level controller of the BMS, wherein, when an unhandleable error occurs during an operation of the battery, the processor stores error occurrence information indicating occurrence of the unhandleable error in a reference area of the memory corresponding to a predefined reference address, and when the BMS wakes up, the processor reads information in the reference area of the memory and transmits a read result to the EMS.

When the error occurrence information is stored in the reference area, the processor may determine that a cause of the unhandleable error is not solved and perform a predefined protection operation to protect the battery.

When notified by the BMS that the error occurrence information is stored in the reference area, the EMS may transmit a trigger signal for triggering a protection operation of the BMS to the BMS.

The ESS may further include a power conversion system (PCS) configured to perform power conversion between the battery and a power grid system, and when notified by the BMS that the error occurrence information is stored in the reference area, the EMS may control the PCS to block a connection between the battery and the power grid system.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram illustrating an energy storage system (ESS) according to embodiments of the present disclosure;
FIG. 2 is a diagram illustrating an example of a circuit structure of a battery management system (BMS) according to embodiments of the present disclosure;
FIG. 3 is a block diagram illustrating the BMS according to embodiments of the present disclosure; and
FIG. 4 is a flowchart illustrating a method of operating a BMS according to embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to one another, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to one another.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

### 1. Energy storage system (ESS) and battery management system (BMS)

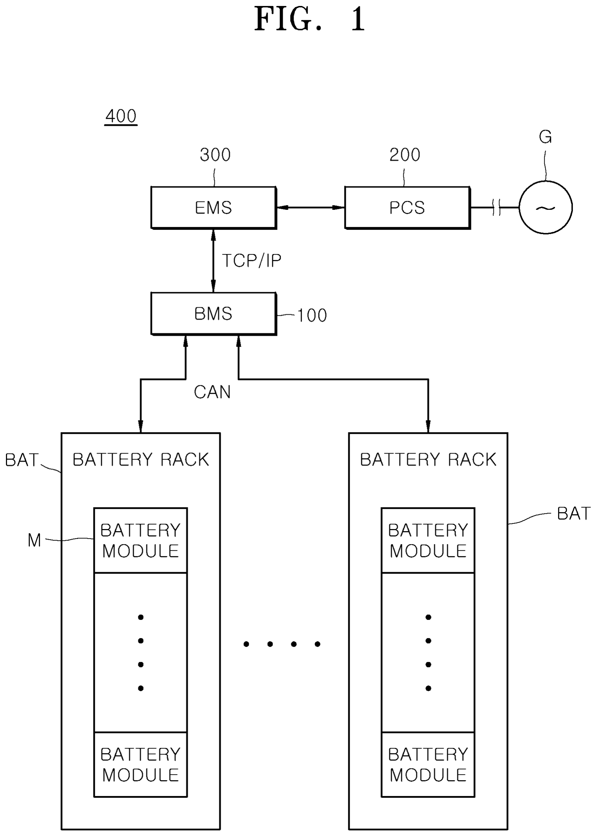

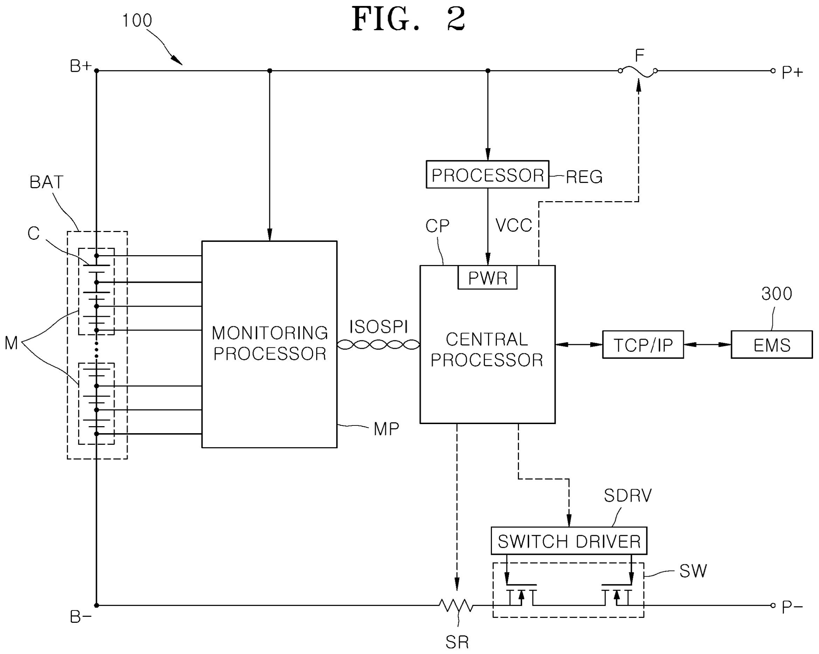

FIG. 1 is a block diagram illustrating an ESS according to embodiments of the present disclosure, and FIG. 2 is a diagram illustrating an example of a circuit structure of a BMS according to embodiments of the present disclosure.

First, referring to FIG. 1, an ESS 400 of the present embodiment may include a battery BAT, a BMS 100, a power conversion system (PCS) 200, and an energy management system (EMS) 300.

The battery BAT may be implemented as a battery rack, and as shown in FIG. 1, a plurality of batteries BAT may be provided in the ESS 400 (hereinafter, the battery BAT is defined to have the same meaning as the battery rack). When the plurality of battery racks BAT are provided, the plurality of battery racks BAT may be connected to one another in series or in parallel. Each battery rack BAT may include a plurality of battery modules M connected in series or in parallel, and each battery module M may include a plurality of battery cells C connected in series or in parallel. The battery BAT may be charged with power supplied from a power grid system G through the PCS 200, and the power charged in the battery BAT may be supplied to the power grid system G through the PCS 200.

The BMS 100 may operate to monitor a state of the battery BAT and perform a control function or a protection function on the battery BAT on the basis of the monitoring result. For example, the BMS 100 monitors a voltage, a current, a temperature, and a state of charge (SOC) of a battery cell C included in the battery BAT and may perform control operations such as balancing control, temperature control, and charging/discharging control of the battery cell C on the basis of the monitoring result or perform a protection operation such as switch control of preventing over-discharging or over-charging. A single BMS 100 may perform control and protection functions for the plurality of battery racks BAT, and alternatively, a single BMS 100 may perform the control and protection functions for a single battery rack BAT. Controller area network (CAN) communication may be used as a communication method between the BMS 100 and the battery rack BAT. In the present embodiment, the BMS 100 may be a rack BMS.

Under the control of the EMS 300, the PCS 200 may serve as a power conversion device that performs AC-DC conversion, voltage size regulation, and frequency conversion to perform power linkage between the battery BAT and the power grid system G. For example, when the battery BAT is charged, the PCS 200 may convert a commercial AC voltage from the power grid system G into a DC voltage, and when the battery BAT is discharged, the PCS 200 may convert a DC voltage from the battery BAT into commercial an AC voltage. In addition, when the ESS 400 of the present embodiment is implemented as a frequency regulation ESS, the PCS 200 may perform a function of supplying power to the power grid system G by performing discharging according to a set speed adjustment rate under frequency droop control of the EMS 300 when a frequency of the power grid system G falls to a preset reference value or less, and when the frequency of the power grid system G becomes the reference value or more, the PCS 200 may perform a function of absorbing energy from the power grid system G by performing charging of the battery BAT, thereby stably maintaining the frequency of the power grid system G.

The EMS 300 may serve as a higher level controller of the BMS 100 and the PCS 200 and serve as an integrated control device that monitors power usage of the power grid system G and power supply of the ESS 400 in real time and controls an operation of the ESS 400. The EMS 300 may monitor states of the battery BAT, the BMS 100, and the PCS 200 and control operations of the BMS 100 and the PCS 200 on the basis of the monitoring results. Transmission control protocol/Internet protocol (TCP/IP) may be applied as a communication protocol between the EMS 300 and the BMS 100.

FIG. 2 shows an example of a circuit structure of the BMS 100 on which the present embodiment focuses.

Referring to FIG. 2, the BMS 100 of the present embodiment may include a monitoring processor MP, a central processor CP, a shunt resistor SR, a charging/discharging switch SW, a switch driver SDRV, a regulator REG, and a fuse F and may be formed to be electrically connected to a plurality of battery cells C included in the battery BAT (i.e., a battery rack).

The monitoring processor MP may correspond to an analog-front-end (AFE) integrated circuit (IC) that monitors a state of each battery cell C and performs a battery cell control operation on the basis of the monitoring results. For example, the monitoring processor MP may monitor a voltage, a current, a temperature, and a state of charge (SOC) of a battery cell C and perform control operations such as balancing control, temperature control, and charging/discharging control of the battery cell C on the basis of the monitoring results or perform a protection operation such as charging/discharging switch SW control to prevent over-discharging or over-charging. The state data of the battery cell C (i.e., the voltage, the current, the temperature, and the SOC of the battery cell C) acquired by the monitoring processors MP may be transmitted to the central processor CP through isolated serial peripheral interface (isoSPI) communication.

The central processor CP may generate a control operation command or a protection operation command on the basis of the state data of the battery cells C transmitted from the monitoring processor MP and feed the control operation command or the protection operation command back to the monitoring processor MP, thereby allowing the monitoring processor MP to perform the control operation or protection operation. The central processor CP performing such functions may correspond to a micro controller unit (MCU) of the BMS 100.

Although the monitoring processor MP and the central processor CP are shown as separate configurations in FIG. 2, an embodiment in which the monitoring processor MP and the central processor CP are implemented as a single IC may be provided. Unless otherwise specified, a processor 110 disclosed in the present specification may be a configuration including the monitoring processor MP and the central processor CP. The processor 110 may communicate with a higher level controller (e.g., the EMS 300) through a communication protocol such as TCP/IP.

The shunt resistor SR is connected to a path (corresponding to a charging/discharging path) from a positive terminal P+ of the battery BAT to a negative terminal P- thereof through the battery cell C and may serve as a resistance element for detecting an excessive current flowing in the battery cell C.

The charging/discharging switch SW may correspond to a metal oxide semiconductor field effect transistor (MOSFET) that controls a current flow on the charging/discharging path, and the switch driver SDRV may correspond to a gate driver that controls an on/off operation of the charging/discharging switch SW under the control of the central processor CP. As will be described herein, the charging/discharging switch SW may be formed to be turned off when a protection operation of the BMS 100 according to a hard fault handling mechanism is performed.

The fuse F may be provided on the charge/discharge path and implemented as, for example, a self control protector (SCP) fuse or a pyro-fuse. When an abnormality occurs in the battery BAT (e.g., when an internal line of the BMS 100 or the ESS 400 is short-circuited due to excessive power consumption of the battery BAT, resulting in an overvoltage of the battery cell C), the central processor CP may operate (fuse) the fuse F to block a current flow in the charging/discharging path. As will be described herein, the fuse F may be formed to be fused when the protection operation of the BMS 100 according to the hard fault handling mechanism is performed.

A device for performing an operation of detecting an overcurrent through the shunt resistor SR, an operation of controlling the on/off operation of the charging/discharging switch SW by controlling the switch driver SDRV when an overcurrent is detected, and an operation of fusing the fuse F may correspond to the monitoring processor MP or the central processor CP. FIG. 2 shows an example in which the device for performing the above operations corresponds to the central processor CP. In this case, the central processor CP may operate to detect a state in which an overcurrent is flowing to the battery cell C through the shunt resistor SR and to fuse the fuse F or control the switch driver SDRV to turn the charging/discharging switch SW off, thereby preventing the battery cell C from burning due to the overcurrent.

The regulator REG may regulate a voltage level at the uppermost node B+ of the plurality of battery cells C to a level corresponding to an operating voltage VCC of the central processor CP, and the operating voltage VCC of the central processor CP may be generated by the regulator REG. The regulator REG may be implemented as a DC/DC converter which converts a voltage at the uppermost node B+ of the plurality of battery cells C into the operating voltage of the central processor CP.

### 2. Hard fault handling mechanism

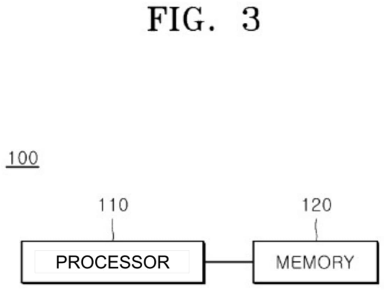

FIG. 3 is a block diagram illustrating the BMS according to embodiments of the present disclosure. Referring to FIG. 3, the BMS 100 may include the processor 110 and a memory 120. As described herein, the processor 110 may be a configuration including the monitoring processor MP and the central processor CP, and the following hard fault handling mechanism may be performed specifically by the central processor CP.

At least one command executed by the processor 110 may be stored in the memory 120. The memory 120 may be implemented as a volatile storage medium and/or a non-volatile storage medium, for example, a read-only memory (ROM), a random access memory (RAM), a flash memory, or an electrically erasable programmable read-only memory (EEPROM).

Generally, software for performing control and protection functions on the battery BAT is applied to the processor 110 of the BMS 100, and an interrupt service routine (ISR) is defined in the software applied to the processor 110 as an exception handling mechanism for handling exceptions that occur during the operation of the BMS 100.

Meanwhile, during the operation of the BMS 100, an error that the processor 110 cannot identify may occur due to a software or hardware defect, and such an unhandleable error is also referred to as a hard fault ("unhandleable error" and "hard fault" described in the present specification have the same meaning). A hard fault is an error, for example, a memory misreference, whose cause can be identified later through user debugging, but which the processor 110 cannot identify why it occurred on its own. Since the processor 110 cannot determine why the hard fault occurred on its own and but the cause of the hard fault can be determined retroactively through the user debugging, it is impossible to define an ISR in advance to handle a hard fault. In some cases, an infinite loop ISR default is implemented through machine language coding when a hard fault occurs (e.g., using a "while" function in a C language). However, from the user's perspective, a situation in which a hard fault has occurred cannot be recognized, and therefore, since the BMS 100 continues to operate in a state in which the cause of the hard fault is not removed (i.e., a state in which a potential error occurrence is inherently present), abnormal operations of the BMS 100 and the ESS 400 may occur. Even when the BMS 100 is shut down (power off) and then woken up (power on) again, the cause of the hard fault remains unresolved and there is still a probability of the hard fault recurring.

In the present embodiment, a hard fault handling mechanism for preventing a situation in which the BMS 100 and the ESS 400 are operated without the cause of a hard fault being removed is proposed.

To implement the hard fault handling mechanism, a cell area of the memory 120 in which data is stored in the present embodiment may be divided into a first area, a second area, and a third area. The first area may be an area in which the battery state data is stored, the second area may be an area in which a command executed by the processor 110 is stored, and the third area may be an area in which error occurrence information, which will be described herein, is stored. An address for referencing each of the first to third areas may be predefined in the processor 110, and the processor 110 may read the battery state data, the command, and the error occurrence information by referencing each area of the memory 120 corresponding to the defined address. In order to clearly distinguish the terms, the third area in which the error occurrence information is stored is defined as a reference area, and an address for referencing the reference area is defined as a reference address.

When an unhandleable error (i.e., a hard fault) occurs during the operation of the battery BAT (which has the same meaning as the operation of the ESS 400), the processor 110 may be formed to store error occurrence information indicating the occurrence of the unhandleable error in the reference area of the memory 120 corresponding to a predefined reference address, read information in the reference area of the memory 120 when the BMS 100 wakes up, and determine whether to start the operation of the battery BAT on the basis of a read result.

Specifically, first, the processor 110 may determine whether an unhandleable error occurs during the operation of the battery BAT. When no ISR for handling the currently occurring error is defined, the processor 110 may determine that the error is an unhandleable error.

When an unhandleable error occurs, the processor 110 may store error occurrence information in the reference area of the memory 120 corresponding to the reference address. The error occurrence information is information indicating that the unhandleable error occurred and may include, for example, an error flag (e.g., binary data having a value of "1"), a time point at which the unhandleable error occurred, and the memory address referenced by the processor 110 when the unhandleable error occurred. The error occurrence information may serve as data that allows a user to identify the cause of the unhandleable error through debugging. When the error occurrence information is stored in the reference area of the memory 120, the processor 110 may transmit the error occurrence information to the EMS 300, and the EMS 300 may provide the error occurrence information received from the processor 110 to the user through a user interface (e.g., an input/output device such as a personal computer (PC)). After the error occurrence information is stored in the reference area of the memory 120 and transmitted to the EMS 300, the processor 110 may enter the BMS 100 into a shutdown mode (power off mode) to prevent the operation of the BMS 100 and the operation of the ESS 400 until the cause of the unhandleable error has been removed.

After the BMS 100 is shut down, a user who has checked the error occurrence information through the user interface may perform debugging on the unhandleable error, and when the unhandleable error is solved through the debugging, the user may delete the error occurrence information stored in the reference area of the memory 120. The above configuration corresponds to a manual debugging task performed by the user, irrelevant to the operation of the processor 110.

Thereafter, when the BMS 100 wakes up (i.e., when the operating power is input in the shutdown mode and the BMS 100 is powered on), the processor 110 first checks the reference address and reads information in the reference area of the memory 120 corresponding to the reference address to determine whether the cause of the unhandleable error is solved by determining whether the error occurrence information is stored in the reference area.

That is, when the error occurrence information is not stored in the reference area, it corresponds to a case in which the cause of the unhandleable error is solved through the user's debugging, and thus in this case, the processor 110 may initiate the operation of the battery BAT normally.

When the error occurrence information is stored in the reference area, and it corresponds to a case in which the user's debugging is not performed and thus the cause of the unhandleable error is not solved, the processor 110 may perform a predefined protection operation to protect the battery BAT without initiating the operation of the battery BAT in order to prevent recurrence of the unhandleable error.

When the protection operation is performed, the processor 110 may block a current flow in the charging/discharging path by turning the charging/discharging switch SW off or fusing the fuse F. Accordingly, an electrical connection between the battery BAT and the power grid system G (or load) may be cut off, preventing the operation of the ESS 400.

After the protection operation is performed, the processor 110 may notify the EMS 300 that the protection operation is performed. In this case, the EMS 300 may provide the user with the corresponding situation through a user interface (e.g., an input/output device such as a PC) to allow the user to recognize a situation in which debugging of the BMS 100 is currently required.

After the protection operation is performed, the processor 110 may directly notify the user that the protection operation has been performed through a separate indicator (not shown) provided in the ESS 400. The indicator may be implemented as a light-emitting diode (LED) or speaker that provides a visual or auditory notification and installed in a specific location within a range where the user may visually or audibly recognize the notification.

Meanwhile, after the BMS 100 wakes up and the processor 110 reads information in the reference area of the memory 120, the processor 110 may notify the EMS 300 that is the upper controller of a read result.

When notified by the BMS 100 that the error occurrence information is stored in the reference area, the EMS 300 may transmit a trigger signal for triggering a protection operation of the BMS 100 thereto. This functions as a redundancy operation to ensure that the protection operation is performed by the BMS 100.

In addition, when notified by the BMS 100 that the error occurrence information is stored in the reference area, the EMS 300 may control the PCS 200 to block the connection between the battery BAT and the power grid system G. Through the protection operation of the BMS 100 and the connection block operation between the battery BAT and the power grid system G through the PCS 200, the battery BAT may be completely electrically separated from the power grid system G and the load.

### 3. Method of operating BMS

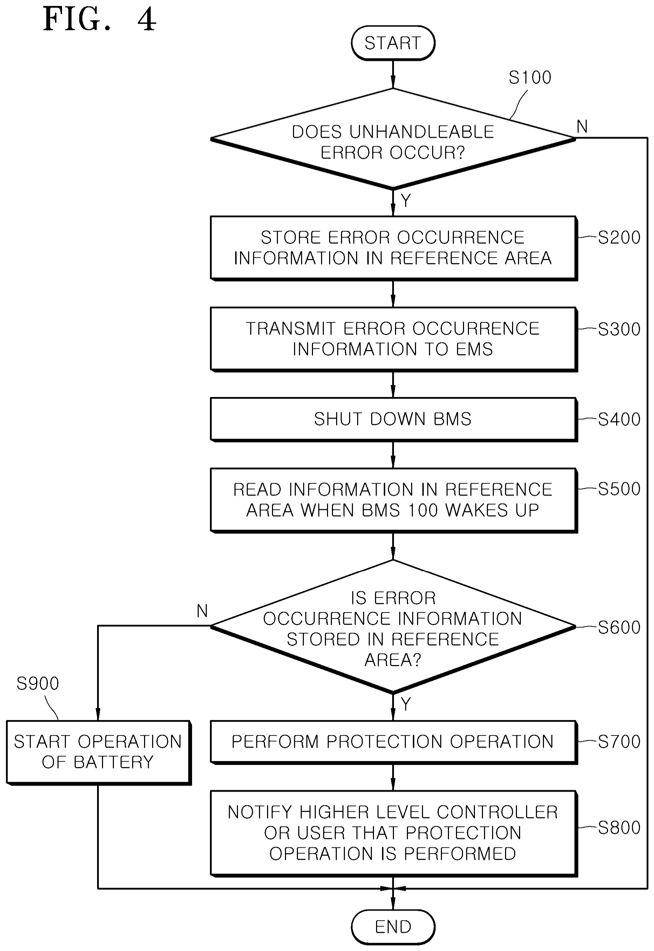

FIG. 4 is a flowchart illustrating a method of operating a BMS according to embodiments of the present disclosure. The method of operating a BMS according to the present embodiment will be described with reference to FIG. 4, wherein detailed description of parts overlapping the herein-described content will be omitted and the description will focus on the time-series structure.

First, the processor 110 determines whether an unhandleable error occurs during the operation of the battery BAT (S100).

When it is determined that an unhandleable error occurs in operation S 100, the processor 110 stores error occurrence information indicating the occurrence of the unhandleable error in the reference area of the memory 120 corresponding to a predefined reference address (S200).

Then, the processor 110 transmits the error occurrence information to the EMS 300 (S300). In this case, the EMS 300 may provide the error occurrence information received from the processor 110 to the user through the user interface.

Next, the processor 110 enters the BMS 100 in a shutdown mode (power off mode) (S400) in order to prevent the operations of the BMS 100 and the ESS 400 until the cause of the unhandleable error is removed.

When BMS 100 wakes up again after shut down through operation S400, the processor 110 reads information in the reference area of the memory 120 (S500).

Next, the processor determines whether to start the operation of the battery BAT on the basis of a reading result of the reference area of the memory 120 (S600).

In operation S600, the processor 110 determines whether the error occurrence information is stored in the reference area and determines whether the cause of the unhandleable error is solved.

When it is determined that the error occurrence information is stored in the reference area in operation S600, the processor 110 determines that the cause of the unhandleable error is not solved and determines not to start the operation of the battery BAT. Thereafter, the processor 110 performs a predefined protection operation (S700). In operation S700, the processor 110 may block a current flow in the charging/discharging path by turning the charging/discharging switch SW off or fusing the fuse F. After the protection operation is performed through operation S700, the processor 110 notifies the higher level controller that the protection operation is performed or notifies the user through an indicator (S800).

Meanwhile, when it is determined that the error occurrence information is not stored in the reference area in operation S600, the processor 110 starts the operation of the battery BAT (S900).

According to the present disclosure, when an unhandleable error whose cause cannot be identified occurs during the operation of the ESS, the error occurrence information is stored in the reference area of the memory 120, and then when the BMS wakes up, information in the reference area of the memory 120 is read, and the operation of the ESS is started or the protection operation is performed according to a read result. Thus, an abnormal operation of the ESS caused by the operation of the ESS in a state in which an occurrence of a potential error is inherent can be prevented, thereby improving operation stability thereof.

Implementations described herein may also be implemented by, for example, a method or process, an apparatus, a software program, a data stream, or a signal. Even when only discussed in the context in a single form of implementation (e.g., discussed only as a method), the implementation of features discussed may also be implemented in other forms (e.g., an apparatus or program). The apparatus may be implemented in suitable hardware, software, and firmware. The method may be implemented in an apparatus such as a processor, which is generally referred to as a processing device including, for example, a computer, a microprocessor, an integrated circuit, or a programmable logic device. The processor also includes communication devices such as computers, cellular phones, portable/personal digital assistants ("PDAs"), and other devices that facilitate information communication of between end-users.

According to the present disclosure, when an unhandleable error whose cause cannot be identified occurs during an operation of an energy storage system (ESS), error occurrence information is stored in a reference area of a memory, and then when a battery management system (BMS) wakes up, information in the reference area of the memory is read, and the operation of the ESS is started or a protection operation is performed according to a read result. Thus, an abnormal operation of the ESS caused by the operation of the ESS in a state in which occurrence of a potential error is inherent can be prevented, thereby improving operation stability thereof.

However, effects that can be achieved through the present disclosure are not limited to the herein-described effects and other effects that are not described may be clearly understood by those skilled in the art from the detailed descriptions.

Although the present disclosure has been described with reference to embodiments and drawings illustrating aspects thereof, the present disclosure is not limited thereto.

## Claims

1. A battery management system, BMS (100), of a battery (BAT) comprising:
a processor (110); and
a memory (120) configured to store a command executed by the processor (110),
wherein, when an unhandleable error occurs during an operation of the battery (BAT), the processor (110) stores error occurrence information indicating occurrence of the unhandleable error in a reference area of the memory (120) corresponding to a predefined reference address, and when the BMS (100) wakes up, the processor (110) reads information in the reference area of the memory (120) and determines whether to start operation of the battery (BAT) on the basis of a read result.

2. The BMS (100) of claim 1, wherein the unhandleable error is an error that is not allowed to be handled through a predefined exception handling mechanism for exception handling during the operation of the battery (BAT).

3. The BMS (100) of claim 1 or 2, wherein, when the BMS (100) wakes up, the processor (110) reads the information in the reference area of the memory (120), determines whether the error occurrence information is stored in the reference area, and determines whether a cause of the unhandleable error is solved.

4. The BMS (100) of claim 3, wherein, when the error occurrence information is stored in the reference area, the processor (110) determines that the cause of the unhandleable error is not solved and performs a predefined protection operation to protect the battery (BAT).

5. The BMS (100) of claim 4, further comprising a switch (SW) connected to a charging/discharging path that functions as a path for supplying a charging current or drawing a discharging current to or from the battery (BAT) and configured to allow or block a current flow in the charging/discharging path,
wherein, when the protection operation is performed, the processor (110) turns the switch off to block the current flow in the charging/discharging path.

6. The BMS (100) of claim 4 or 5, further comprising a fuse (F) connected to a charging/discharging path that functions as a path for supplying a charging current or drawing a discharging current to or from the battery (BAT) and configured to block a current flow in the charging/discharging path when fused,
wherein, when the protection operation is performed, the processor (110) fuses the fuse (F) to block the current flow in the charging/discharging path.

7. The BMS (100) of any one of the claims 4 to 6, wherein, after the protection operation is performed, the processor (110) notifies a higher level controller that the protection operation is performed or notifies a user through an indicator.

8. The BMS (100) of any one of the claims 3 to 7, wherein, when the error occurrence information is not stored in the reference area, the processor (110) starts operation of the battery (BAT).

9. The BMS (100) of any one of the preceding claims, wherein the reference address has an address value different from an address of a storage area of the memory (120) in which the command is stored.

10. A method of operating a battery management system, BMS, comprising:
determining, by a processor (110), whether an unhandleable error occurs during an operation of a battery (BAT);
when it is determined that the unhandleable error occurs, storing, by the processor (110), error occurrence information indicating occurrence of the unhandleable error in a reference area of a memory (120) corresponding to a predefined reference address;
when the BMS (100) wakes up, reading, by the processor (110), information in the reference area of the memory (120); and
determining, by the processor (110), whether to start operation of the battery (BAT) on the basis of a read result of the reference area of the memory (120).

11. The method of claim 10, wherein the determining whether to start operation of the battery (BAT) includes determining, by the processor (110), whether the error occurrence information is stored in the reference area and determining whether a cause of the unhandleable error is solved.

12. The method of claim 11, further comprising:
when it is determined that the error occurrence information is stored in the reference area, determining, by the processor (110), that the cause of the unhandleable error is not solved and determining not to start operation of the battery (BAT); and
when it is determined not to start the operation of the battery (BAT), performing, by the processor (110), a predefined protection operation.

13. An energy management system, ESS (400), including the battery management system, BMS (100), of any one of the claims 1 to 9.

14. A computer program comprising instructions to cause the battery management system, BMS, of any one of the claims 1 to 9 to execute the steps of the method of any one of the claims 10 to 12

15. A computer-readable medium having stored thereon the computer program of claim 14.
